# FASCICULE DE BREVET EUROPEEN

(11) **EP 2 487 492 B1**
(45) Date de publication et mention de la délivrance du brevet: **19.03.2014**
(21) Numéro de dépôt: 12151709.8
(22) Date de dépôt: 19.01.2012
(51) Int. Cl.: G01R 1/067, G01R 31/02, G01R 31/08, H04M 3/30

(54) **Procédé de test électrique d'un réseau de paires de conducteurs**
Verfahren zum elektrischen Testen eines Netzes von paarweisen Leitern
Method for electrically testing a network of conductor pairs

(30) Priorité: 11.02.2011 FR 1151126
(43) Date de publication de la demande: 15.08.2012
(73) Titulaire: Nexans, 75008 Paris (FR)
(72) Inventeur: Philips, Guillaume, 08300 SAULT-LES-RETHEL (FR); Lima, Cyril, 08000 Charleville-Mezieres (FR)
(74) Mandataire: Gauer, Pierre

(56) Documents cités:
- WO-A2-2005/006784
- US-A1- 2001 033 174
- US-A1- 2010 074 415
- US-B1- 6 201 853
- US-B1- 6 215 856
- US-B1- 6 970 534

## Description

La présente invention a pour objet un procédé de test électrique d'un réseau de paires de conducteurs.

Les réseaux de télécommunication sont constitués de câbles interconnectés qui permettent de desservir des abonnés. Les câbles comprennent de nombreuses paires de conducteurs, généralement du cuivre, de faible diamètre, et peuvent être aériens ou souterrains.

Il peut arriver qu'un abonné rencontre un problème de connexion, causé par exemple par un fil mal connecté dans le réseau, ou par un court-circuit provoqué par l'humidité.

Un technicien doit alors intervenir sur le réseau pour localiser la perturbation. Il utilise à cet effet un dispositif de test électrique qu'il branche à différents points de connexion, ainsi qu'une réglette de connexion à coupure, de manière à isoler la ligne, et vérifie ensuite si la perturbation du réseau se situe en amont ou en aval des points de connexion.

Les dispositifs de test connus sont des cordons à coupure équipés en sortie de deux paires de conducteurs, une pour l'amont et l'autre pour l'aval du point de connexion. Pour tester de l'amont vers l'aval ou inversement, il faut donc débrancher une paire et rebrancher l'autre paire, ce qui entraîne des pertes de temps et des erreurs liées au mélange des paires.

On connaît des documents FR 2 524 150, GB 2 378 608 et US 4 139 745 différents dispositifs de connexion électrique. De plus, les documents WO 2005/006784 A2 et US 6970534 B1 divulguent différents procédés de test électrique. Ces documents ne mentionnent toutefois pas de procédé de test électrique permettant de diagnostiquer une perturbation en amont ou en aval d'un réseau muni d'une réglette de connexion à coupure, sans avoir à débrancher les paires de conducteurs du dispositif de test.

La présente invention vise à remédier à ces inconvénients.

Elle propose en particulier un procédé de test électrique permettant de diagnostiquer si une perturbation du réseau se situe en amont ou en aval d'un point de connexion sans avoir à débrancher les paires de conducteurs du dispositif.

L'invention a ainsi pour objet un procédé de test électrique d'un réseau de paires de conducteurs comprenant au moins une réglette de connexion à coupure.

Le procédé met en oeuvre un dispositif de test électrique comprenant:
- une première extrémité munie d'une paire de conducteurs et destinée à être connectée à un appareil de test,
- une deuxième extrémité munie de deux paires de conducteurs, une paire étant destinée à être connectée à une première zone du réseau située en amont de la réglette de connexion, l'autre paire étant destinée à être connectée à une deuxième zone du réseau située en aval de la réglette de connexion, et
- un commutateur apte à connecter alternativement la paire de conducteurs de la première extrémité à chacune des deux paires de conducteurs de la deuxième extrémité.

Le procédé selon l'invention comprend:
- une première étape de test en amont de la réglette de connexion, en basculant le commutateur de manière à connecter la paire de conducteurs de la première extrémité à une paire de conducteurs de la deuxième extrémité du dispositif en amont de la réglette de connexion, et
- une deuxième étape de test en aval de la de la réglette de connexion, en basculant le commutateur de manière à connecter la paire de conducteurs de la première extrémité à la deuxième paire de conducteurs de la deuxième extrémité du dispositif en aval de la réglette de connexion.

La première extrémité peut être munie de deux fiches bananes, d'un connecteur RJ qui provient du terme « Registered Jack » en langue anglaise, signifiant prise jack enregistrée), de deux pinces crocodiles, ou de deux fils nus, suivant l'appareil de test utilisé.

Le réseau est un réseau comprenant au moins une réglette de connexion à coupure, reliant par exemple une zone amont du réseau et une zone aval du réseau.

Le réseau peut par exemple comprendre un central téléphonique ou une armoire de rue.

Le central téléphonique peut comprendre un multiplexeur et deux réglettes de connexion à coupure disposées entre le multiplexeur et des abonnés.

La deuxième extrémité du dispositif peut être connectée à une des réglettes de connexion.

D'autres caractéristiques et avantages de la présente invention apparaîtront plus clairement à la lecture de la description suivante donnée à titre d'exemple illustratif et non limitatif et faite en référence aux dessins annexés sur lesquels :
- la figure 1 illustre un dispositif de test utilisé dans le procédé selon l'invention,
- la figure 2 illustre schématiquement une partie du dispositif, et
- la figure 3 illustre sous forme de schéma bloc un réseau dans lequel peut être mis en oeuvre le procédé selon l'invention.

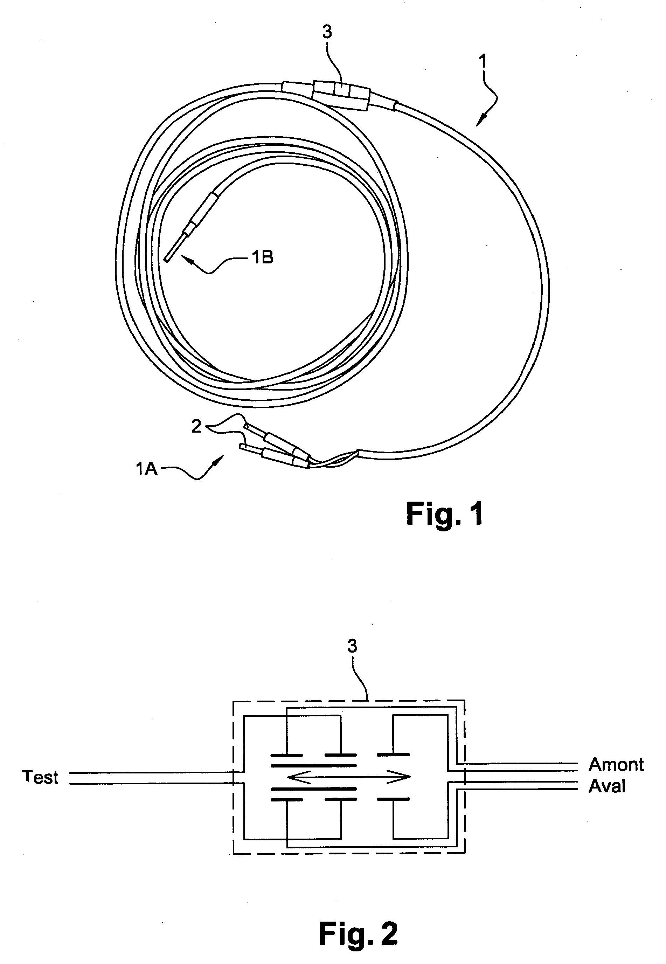

Le dispositif 1 de test électrique utilisé selon l'invention, tel qu'illustré à la figure 1, est un cordon qui comprend une première extrémité 1A munie d'une paire de conducteurs et destinée à être connectée à un appareil de test. L'appareil de test peut par exemple permettre d'effectuer un test de continuité électrique ou de lancer différents signaux pour tester la réaction des signaux. La première extrémité 1A est par exemple munie de deux fiches bananes 2, chaque fiche 2 étant connectée à un conducteur.

Le dispositif 1 comprend également une deuxième extrémité 1B munie de deux paires de conducteurs, une paire étant destinée à être connectée à une première zone du réseau, par exemple en amont du point de connexion sur lequel on branche le dispositif 1, l'autre paire étant destinée à être connectée à une deuxième zone du réseau, par exemple en aval du point de connexion. Tel qu'illustré à la figure 1, les deux paires de conducteurs sont présentes dans un embout 1B qui est un circuit imprimé avec quatre points de connexion.

Conformément à l'invention, le dispositif 1 comprend en outre un commutateur 3 (ou interrupteur ou inverseur) apte à connecter la paire de conducteurs de la première extrémité 1A à l'une des deux paires de conducteurs de la deuxième extrémité 1B. Le commutateur 3 peut comprendre deux positions, connectant la paire de conducteurs de la première extrémité 1A à chacune des deux paires de conducteurs de la deuxième extrémité 1B. Par exemple, une première position du commutateur 3 peut connecter la paire de conducteurs de la première extrémité 1A à une paire située en amont du point de connexion, tandis qu'une deuxième position du commutateur 3 connecte la paire de conducteurs de la première extrémité 1A à une paire située en aval du point de connexion.

Tel qu'illustré à la figure 2, le commutateur 3 permet de connecter alternativement la paire de conducteurs située du côté de l'appareil de test à chacune des paires de conducteurs amont/aval situées du côté de l'abonné. On peut ainsi effectuer des tests vers l'amont ou vers l'aval sans débrancher le dispositif 1 du module de raccordement et de l'appareil de test.

Le procédé selon l'invention peut être avantageusement utilisé sur une réglette de connexion à coupure de manière à tester une zone située en amont de la réglette et une zone située en aval de la réglette.

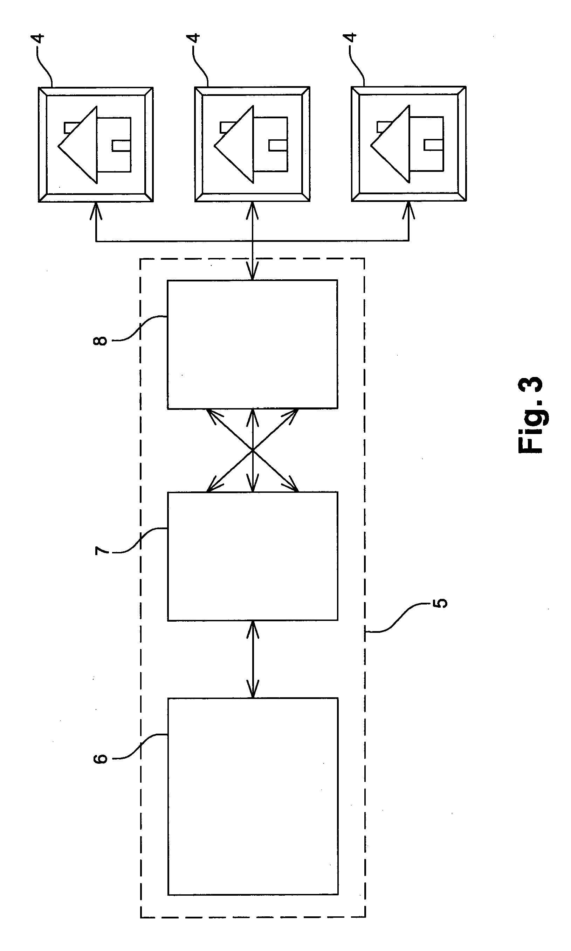

Un exemple d'une telle architecture est illustré à la figure 3.

La figure 3 illustre une architecture de raccordement d'un abonné au réseau téléphonique. Des abonnés 4 sont raccordés à un réseau téléphonique via un central téléphonique 5. Le central téléphonique 5 comprend un multiplexeur 6 et deux réglettes 7,8 de connexion à coupure disposées entre le multiplexeur 6 et les abonnés 4.

Le multiplexeur 6 peut être par exemple un DSLAM (« Digital Subscriber Line Access Multiplexer » en langue anglaise, soit en langue française : « Multiplexeur d'Accès à la Ligne d'Abonné Numérique »).

Le DSLAM 6 récupère le trafic de données, issu de l'utilisation des technologies DSL transitant sur les lignes téléphoniques qui lui sont raccordées, après que ce trafic a été séparé du trafic de voix issu de la téléphonie classique, grâce à un filtre. Ensuite le DSLAM 6 regroupe le trafic des différentes lignes qui lui sont raccordées et le redirige vers le réseau de l'opérateur ou du fournisseur d'accès.

Les deux réglettes 7,8 de connexion à coupure sont des éléments en matière plastique munis de contacts sur lesquels on vient connecter les câbles. La fonction coupure permet d'isoler la ligne. Une première réglette 7 est reliée au multiplexeur 6 et une deuxième réglette 8 est reliée aux abonnés 4. Les deux réglettes 7,8 sont reliées entre elles à l'aide de jarretières en cuivre.

Le dispositif de test peut être appliqué à un point de connexion situé sur la première réglette 7 ou sur la deuxième réglette 8. Par exemple, l'utilisation du dispositif dans la première réglette 7 permet de déterminer si une perturbation est située du côté du multiplexeur 6 ou du côté de la deuxième réglette 8.

## Revendications

1. Procédé de test électrique d'un réseau de paire de conducteurs comprenant au moins une réglette (7,8) de connexion à coupure reliant une zone amont du réseau et une zone aval du réseau, **caractérisé en ce que** le procédé met en oeuvre un dispositif (1) de test électrique comprenant :
- une première extrémité (1A) munie d'une paire de conducteurs et destinée à être connectée à un appareil de test,
- une deuxième extrémité (1B) munie de deux paires de conducteurs, une paire étant destinée à être connectée à une première zone du réseau (5) située en amont de la réglette de connexion (7,8), l'autre paire étant destinée à être connectée à une deuxième zone du réseau (5) située en aval de la réglette de connexion (7,8), et
- un commutateur (3) apte à connecter alternativement la paire de conducteurs de la première extrémité (1A) à chacune des deux paires de conducteurs de la deuxième extrémité (1B),
et **en ce que** le procédé comprend :
- une première étape de test en amont de la réglette de connexion (7,8), en basculant le commutateur (3) de manière à connecter la paire de conducteurs de la première extrémité (1A) à une paire de conducteurs de la deuxième extrémité (1B) du dispositif (1) en amont de la réglette de connexion (7,8), et
- une deuxième étape de test en aval de la de la réglette de connexion (7,8), en basculant le commutateur (3) de manière à connecter la paire de conducteurs de la première extrémité (1A) à la deuxième paire de conducteurs de la deuxième extrémité (1B) du dispositif (1) en aval de la réglette de connexion (7,8).

2. Procédé selon la revendication 1, **caractérisé en ce que** la première extrémité (1A) est munie de deux fiches bananes (2), d'un connecteur RJ, de deux pinces crocodiles, ou de deux fils nus.

3. Procédé selon la revendication 1 ou 2, **caractérisé en ce que** le réseau (5) comprend un central téléphonique (5) ou une armoire de rue.

4. Procédé selon la revendication 3, **caractérisé en ce que** le central téléphonique (5) comprend un multiplexeur (6) et deux réglettes (7,8) de connexion disposées entre le multiplexeur (6) et des abonnés (4).

5. Procédé selon la revendication 4, **caractérisée en ce que** la deuxième extrémité (1B) du dispositif (1) est connectée à une des réglettes (7,8) de connexion.

## Patentansprüche

1. Verfahren zum elektrischen Testen eines Netzes von Leiterpaaren, das mindestens eine Unterbrechungs-Anschlussleiste (7, 8) umfasst, die eine vorgelagerte Zone des Netzes und eine nachgelagerte Zone des Netzes verbindet, **dadurch gekennzeichnet, dass** das Verfahren eine elektrische Testvorrichtung (1) umsetzt, die umfasst:
- ein erstes Ende (1A), das mit einem Leiterpaar ausgestattet ist und dazu bestimmt, mit einem Testgerät verbunden zu sein,
- ein zweites Ende (1B), das mit zwei Leiterpaaren ausgestattet ist, wobei ein Paar dazu bestimmt ist, mit einer ersten Zone des Netzes (5) verbunden zu sein, die sich der Anschlussleiste (7, 8) vorgelagert befindet, wobei das andere Paar dazu bestimmt ist, mit einer zweiten Zone des Netzes (5) verbunden zu sein, die sich der Anschlussleiste (7, 8) nachgelagert befindet, und
- einen Umschalter (3) der imstande ist, alternativ des Leiterpaar des ersten Endes (1A) mit jedem der zwei Leiterpaare des zweiten Endes (1B) zu verbinden,
und dass das Verfahren umfasst:
- einen ersten der Anschlussleiste (7, 8) vorgelagerten Testschritt durch Kippen des Umschalters (3) derart, dass das Leiterpaar des ersten Endes (1A) mit einem Leiterpaar des zweiten Endes (1B) der Vorrichtung (1) vor der Anschlussleiste (7, 8) verbunden ist, und
- einen zweiten der Anschlussleiste (7, 8) nachgelagerten Testschritt durch Kippen des Umschalters (3) derart, dass das Leiterpaar des ersten Endes (1A) mit dem zweiten Leiterpaar des zweiten Endes (1B) der Vorrichtung (1) nach der Anschlussleiste (7, 8) verbunden ist.

2. Verfahren nach Anspruch 1, **dadurch gekennzeichnet, dass** das erste Ende (1A) mit zwei Bananensteckern (2), einem RJ-Verbinder und zwei Krokodilklemmen oder mit zwei nackten Drähten ausgestattet ist.

3. Verfahren nach Anspruch 1 oder 2, **dadurch gekennzeichnet, dass** das Netz (5) eine Telefonzentrale (5) oder einen Schrank am Straßenrand umfasst.

4. Verfahren nach Anspruch 3, **dadurch gekennzeichnet, dass** die Telefonzentrale (5) einen Multiplexer (6) und zwei Anschlussleisten (7, 8) umfasst, die zwischen dem Multiplexer (6) und Abonnenten (4) angeordnet sind.

5. Verfahren nach Anspruch 4, **dadurch gekennzeichnet, dass** das zweite Ende (1B) der Vorrichtung (1) mit einer der Anschlussleisten (7, 8) verbunden ist.

## Claims

1. A method for electrically testing a network of conductor pairs comprising at least one connection strip with integrated cut off (7, 8) connecting an upstream zone of the network and a downstream zone of the network, **characterized in that** the method uses an electrical testing device comprising:
- a first end (1A) provided with a pair of conductors and designed to be connected to a testing apparatus,
- a second end (1 B) provided with two conductor pairs, one pair being designed to be connected to a first zone of the network (5) situated upstream from the connection strip (7, 8), the other pair being designed to be connected to a second zone of the network (5) situated downstream from the connection strip (7, 8), and
- a switch (3) capable of alternatingly connecting the conductor pair of the first end (1 A) to each of the two conductor pairs of the second end (1 B),
and **in that** the method comprises:
- a first testing step upstream from the connection strip (7, 8), by switching the switch (3) so as to connect the conductor pair of the first end (1A) to the conductor pair of the second end (1B) of the device (1) upstream from the connection strip (7, 8), and
- a second test step downstream from the connection strip (7, 8), by switching the switch (3) so as to connect the conductor pair of the first end (1A) to the second conductor pair of the second end (1 B) of the device (1) downstream from the connection tab (7, 8).

2. The method according to claim 1, **characterized in that** the first end (1A) is provided with two banana pins (2), an RJ connector, two alligator clips, or two stripped wires.

3. The method according to claim 1 or 2, **characterized in that** the network (5) comprises a telephone exchange (5) or a street cabinet.

4. The method according to claim 3, **characterized in that** the telephone exchange (5) comprises a multiplexer (6) and two connection strips (7, 8) positioned between the multiplexer (6) and the subscribers (4).

5. The method according to claim 4, **characterized in that** the second end (1 B) of the device (1) is connected to one of the connection strips (7, 8).
